# EUROPEAN PATENT APPLICATION

(11) **EP 4 528 830 A1**
(43) Date of publication of application: **26.03.2025**
(21) Application number: 22957638.4
(22) Date of filing: 05.09.2022
(51) Int. Cl.: H01L 31/0725, H01L 31/18

(54) **PEROVSKITE SOLAR CELL, MANUFACTURING METHOD THEREFOR AND ELECTRIC APPARATUS**

(71) Applicant: Contemporary Amperex Technology Co., Limited, Ningde, Fujian 352100 (CN)
(72) Inventor: CHEN, Guodong, Ningde, Fujian 352100 (CN); TU, Bao, Ningde, Fujian 352100 (CN); HUANG, Zhihan, Ningde, Fujian 352100 (CN); CHEN, Changsong, Ningde, Fujian 352100 (CN); SU, Shuojian, Ningde, Fujian 352100 (CN); LIU, Zhaohui, Ningde, Fujian 352100 (CN); GUO, Yongsheng, Ningde, Fujian 352100 (CN)
(74) Representative: Holt, Lucy Rose
(86) International application number: PCT/CN2022/117050
(87) International publication number: WO 2024/050662

(57) **Abstract**

The present application relates to a perovskite solar cell, a manufacturing method therefor and an electric apparatus. The perovskite solar cell comprises a bottom electrode, a perovskite layer and a top electrode, the perovskite layer comprising a plurality of layers of sub-perovskite films which are stacked, and band gaps of adjacent two layers of sub-perovskite films being different. The perovskite solar cell can expand a spectral absorption and conversion range, has a controllable thickness and controllable band gaps and has no defect layer, so that band gaps of an absorption and conversion layer are adjustable, thereby effectively expanding the spectral absorption and conversion range, and improving an external output of the perovskite solar cell.

## Description

### Technical Field

The present application relates to the technical field of solar cells, in particular to a perovskite solar cell and a preparation method therefor and a power consuming device.

### Background Art

Perovskite solar cells are solar cells comprising a perovskite organic metal halide semiconductor as a light-absorbing material, which belong to the third generation of solar cells, and also known as new concept solar cells.

A key component of perovskite solar cells is a perovskite layer as an absorption and conversion layer. A traditional perovskite layer has a band gap as a fixed value according to the material formulation, about 1.6 eV, and therefore, the main absorption range of the perovskite layer to the solar spectrum is in the visible light band, such that it is impossible to absorb and convert the spectral energy in the visible light and near infrared band to the maximum, which will limit the improvement of the efficiency of a device.

A stacked cell is made by forming a series structure in stack with two separate absorption layers with different band gaps by means of an independent manner similar to two-junction cells and an intermediate tunneling layer, and can also be referred to as a two-terminal stacked cell. A four-terminal stacked cell is a structure in which two completely independent cell assemblies are mechanically bonded to form a series-parallel output. Although the stacked cell and the four-terminal stacked cell have solved the problem of a single band gap of a single perovskite layer to a certain extent, the band gap of each-junction cell thereof is unique, and in the process of connecting two-junction cells with independent and different band gap structures, the problems of current matching, the preparation of a tunneling junction, the additional light absorption loss of a substrate material, etc., need to be considered, and in addition, the use of perovskite solar cells is greatly limited in terms of process steps and cost control.

### Summary of the Invention

In order to achieve the above objects, a first aspect of the present application provides a perovskite solar cell, comprising a bottom electrode, a perovskite layer and a top electrode, wherein the perovskite layer comprises several layers of sub-perovskite films arranged in stack, and the band gaps of two adjacent layers of the sub-perovskite films are different.

The above-mentioned perovskite solar cells can increase the spectral absorption and conversion range, and the sub-perovskite films are independent of each other, with controllable thickness and band gap and no defect layer, such that the band gap of an absorption and conversion layer can be adjusted, thereby the spectral absorption and conversion range is effectively increased and the external output of perovskite solar cells is improved.

In an embodiment, band gaps of the several layers of the sub-perovskite films sequentially vary from large to small; and optionally, the bottom electrode is a transparent electrode, and the band gaps of the several layers of the sub-perovskite films sequentially vary from large to small in the direction from the bottom electrode to the top electrode. Thus, it conforms to the characteristics of photovoltaic cells with respect to spectral absorption, and allows the spectral absorption and conversion range to increase.

In an embodiment, the sub-perovskite films have a number of layers of 2-10; optionally, the sub-perovskite films have a number of layers of 2-5; and further optionally, the sub-perovskite films have a number of layers of 2-3.

In an embodiment, the band gap difference between two adjacent layers of the sub-perovskite films is 0.01 eV-0.5 eV; optionally, the band gap difference between two adjacent layers of the sub-perovskite films is 0.05 eV-0.2 eV; and further optionally, the band gap difference between two adjacent layers of the sub-perovskite films is 0.08 eV-0.12 eV. By means of designing the sub-perovskite films according to the difference gradient, the optimum absorption corresponding to different spectral bands can be achieved, the light wave energy of different wavelengths in the spectrum is maximized, and the photoelectric absorption and conversion efficiency is improved.

In an embodiment, the several layers of sub-perovskite films include at least one wide-band-gap layer and one narrow-band-gap layer, wherein the wide-band-gap layer has a band gap G_{w} of 1.2 eV-2.0 eV, the narrow-band-gap layer has a band gap Gₙ of 0.8 eV-1.8 eV, and Gₙ ≤ G_{w}.

In an embodiment, the sub-perovskite film is an evaporated film.

In an embodiment, the sub-perovskite film has a thickness of 200 nm-2 µm; optionally, the sub-perovskite films have a thickness of 300 nm-1 µm; and further optionally, the sub-perovskite films have a thickness of 300 nm-600 nm.

In an embodiment, a material of the sub-perovskite film is selected from one or more of compounds as represented by the following structural formula (I):

ABX₃ (I)

wherein A represents one or more mixed cations; and optionally, A comprises one or more of a methylamine cation, a formamidine cation and a cesium ion;
B represents one or more mixed cations; optionally, B comprises one or more mixed metal cations; and further optionally, B comprises one or more of Pb²⁺, Sn²⁺ and Ge²⁺; and
X represents one or more mixed halide anions; and optionally, X comprises one or more of Cl⁻, Br⁻ and I⁻.

In one embodiment, the perovskite solar cell is a thin film cell.

The second aspect of the present application provides a method for preparing a perovskite solar cell, the method comprising the steps of:
preparing a perovskite layer on a surface of the bottom electrode, the perovskite layer comprising several layers of sub-perovskite films arranged in stack, and the band gaps of two adjacent layers of the sub-perovskite films being different; and
preparing a top electrode on the surface of the perovskite layer.

In an embodiment, the sub-perovskite films are prepared by means of an evaporation method. The preparation of sub-perovskite films by means of an evaporation method can ensure the independence of the sub-perovskite films.

In an embodiment, when the sub-perovskite films are prepared by means of the evaporation method, at least one of the following characteristics is satisfied:
(1) an evaporation temperature is 100°C-300°C;
(2) an evaporation distance is 10 cm-50 cm; and optionally, the evaporation distance is 10 cm-30 cm;
(3) a degree of vacuum is (0.5 - 3) × 10⁻⁶ mbar;
(4) during the evaporation, the substrate is rotated, at a substrate temperature of 15°C-30°C;
   and
(5) after the evaporation of several layers of perovskite films is completed, an annealing step is also included; and optionally, the annealing conditions include: a temperature of 110°C-140°C and a time of 3-20 minutes.

The third aspect of the present application provides a power consuming device, comprising a perovskite solar cell selected from a perovskite solar cell of the first aspect or a perovskite solar cell prepared by means of a preparation method of the second aspect.

### Brief Description of the Drawings

Fig. 1 is a schematic diagram of band gap matching of a wide-band-gap layer and a narrow-band-gap layer in an example and thicknesses thereof;
FIG. 2 is a schematic diagram of an absorption spectrum of a perovskite solar cell in an example.

### Detailed Description of Embodiments

Hereinafter, embodiments of the perovskite solar cell and preparation method therefor and the power consuming device of the present application are disclosed in detail appropriately with reference to the detailed description of the drawings. However, unnecessary detailed illustrations may be omitted in some instances. For example, there are situations where detailed description of well known items and repeated description of actually identical structures are omitted. This is to prevent the following description from being unnecessarily verbose, and facilitates understanding by those skilled in the art. Moreover, the accompanying drawings and the descriptions below are provided for enabling those skilled in the art to fully understand the present application, rather than limiting the subject matter disclosed in the claims.

The "ranges" disclosed in the present application are defined in the form of lower and upper limits. A given range is defined by selecting a lower limit and an upper limit, and the selected lower and upper limits defining the boundaries of the particular range. Ranges defined in this manner may be inclusive or exclusive, and may be arbitrarily combined, that is, any lower limit may be combined with any upper limit to form a range. For example, if the ranges 60-120 and 80-110 are listed for a particular parameter, it should be understood that the ranges 60-110 and 80-120 are also contemplated. Additionally, if minimum range values 1 and 2 are listed and maximum range values 3, 4, and 5 are listed, the following ranges are all contemplated: 1-3, 1-4, 1-5, 2-3, 2-4, and 2-5. In the present application, unless stated otherwise, the numerical range "a-b" denotes an abbreviated representation of any combination of real numbers between a and b, where both a and b are real numbers. For example, the numerical range "0-5" means that all the real numbers between "0-5" have been listed herein, and "0-5" is just an abbreviated representation of combinations of these numerical values. In addition, when a parameter is expressed as an integer ≥ 2, it is equivalent to disclosing that the parameter is, for example, an integer of 2, 3, 4, 5, 6, 7, 8, 9, 10, 11, 12, etc.

All the embodiments and optional embodiments of the present application can be combined with one another to form new technical solutions, unless otherwise stated.

All technical features and optional technical features of the present application can be combined with one another to form a new technical solution, unless otherwise stated.

Unless otherwise stated, all the steps of the present application may be performed sequentially or randomly, preferably sequentially. For example, the method including steps (a) and (b) indicates that the method may include steps (a) and (b) performed sequentially, and may also include steps (b) and (a) performed sequentially. For example, reference to "the method may further include step (c)" indicates that step (c) may be added to the method in any order, e.g., the method may include steps (a), (b) and (c), or steps (a), (c) and (b), or steps (c), (a) and (b), etc.

The terms "comprise" and "include" mentioned in the present application are open-ended or may also be closed-ended, unless otherwise stated. For example, "comprise" and "include" may mean that other components not listed may further be comprised or included, or only the listed components may be comprised or included.

In the present application, the term "or" is inclusive unless otherwise specified. For example, the phrase "A or B" means "A, B, or both A and B". More specifically, the condition "A or B" is satisfied by any one of the following: A is true (or present) and B is false (or not present); A is false (or not present) and B is true (or present); or both A and B are true (or present).

At present, an absorption and conversion layer of perovskite solar cells has a unique band gap, and has a limited absorption spectrum range, resulting in that the improvement of the efficiency is limited and a structural design with a high efficiency, a low cost and a larger current matching window cannot be achieved. In addition, in the stacked cell and the four-terminal stacked cell, the problems of current matching, the preparation of a tunneling junction, the additional light absorption loss of a substrate material, etc., need to be considered, the process steps are relatively cumbersome and the cost is high. Therefore, it is necessary to provide a perovskite solar cell that can increase the spectral absorption and conversion range and has adjustable band gaps of an absorption and conversion layer, so as to provide a wider window for the industrialization and technical improvement of perovskite solar cells.

In addition, in a traditional method for preparing a perovskite layer, a solvent method is commonly used, that is, a material of a perovskite layer are formulated into a solution, and is applied to form a perovskite layer, but by means of such a method, it is difficult to obtain multilayer and independent sub-perovskite films with different band gaps, because if the solution is applied again on a surface of a first perovskite layer, the solution will dissolve some of the surface material of the first perovskite layer, resulting in that the band gap interface and the thickness of the perovskite layer cannot be effectively controlled, the interface is blurred, and even a new defect layer is formed at the interface. Also in a method, it is attempted to bring two perovskite layers with different band gaps in contact with each other, and perform ion permeation by means of the selection of materials to form gradient band gaps, but the process of the ion exchange is uncontrollable, so it is also difficult to obtain multilayer and independent sub-perovskite films with different band gaps, and the ion exchange will eventually reach equilibrium, the formed gradient band gaps are only in a temporary state, and it is likely that a single-band-gap perovskite layer will eventually be formed. It can be seen that by means of a traditional method, multilayer and independent sub-perovskite films with different band gaps cannot be obtained. In addition, the traditional method also has problems of a high process implementation cost, a small window, complicated post-processing, etc.

In view of this, the present application provides a perovskite solar cell, which comprises a bottom electrode, a perovskite layer and a top electrode, wherein the perovskite layer comprises several layers of sub-perovskite films arranged in stack, and the band gaps of two adjacent layers of the sub-perovskite films are different.

It can be understood that "several layers" refers to two layers or more. Without limitation, it can be two layers, three layers, four layers or more.

It can be understood that the "film" in the sub-perovskite film refers to a layer structure that can exist independently, the size of the band gap thereof is determined, and there is a clear interface between the layers, and there is no interpenetration or interdoping at a macroscopic level.

In a perovskite layer of the perovskite solar cell, several layers of sub-perovskite films have different band gaps (the size of the band gap can be adjusted by means of e.g. the type and composition of elements), can increase the spectral absorption and conversion range, and the sub-perovskite films are independent of each other, with controllable thickness and band gap and no defect layer, such that the band gap of an absorption and conversion layer can be adjusted, and thus the spectral absorption and conversion range is effectively increased and the external output of perovskite solar cells is improved. In addition, the perovskite solar cell further has the following advantages:
(1) compared with the stacked cell, the four-terminal stacked cell, etc., there is no need to consider current matching, the preparation of a tunneling junction, the additional light absorption loss of a substrate material, etc., the difficulty of a structural design is reduced while the performance of perovskite solar cells is improved, and the process steps are simple, the window is wide, the preparation cost is low, and the perovskite solar cell is convenient for large-scale and large-size production and application;
(2) several layers of perovskite films have different band gaps, which can effectively convert more spectral energy and increase the improvement space for the current density of a device;
(3) it can match the optimum absorption at different band spectra to achieve the purpose of maximum light absorption and conversion; and
(4) even after the preparation of the perovskite layer is completed, an online process can still be used to achieve the transition treatment of an interface as required, further widening the process window.

In some examples, the band gaps of the several layers of the sub-perovskite films sequentially vary from large to small. Further, the bottom electrode is a transparent electrode, and the band gaps of the several layers of the sub-perovskite films sequentially vary from large to small in the direction from the bottom electrode to the top electrode. Thus, it conforms to the characteristics of photovoltaic cells with respect to spectral absorption, and allows the spectral absorption and conversion range to increase.

In some examples, the sub-perovskite films have a number of layers of 2-10; further, the sub-perovskite films have a number of layers of 2-5; and still further, the sub-perovskite films have a number of layers of 2-3.

In some examples, the band gap difference between two adjacent layers of the sub-perovskite films is 0.01 eV-0.5 eV. Specifically, the band gap difference between two adjacent layers of the sub-perovskite films includes but is not limited to: 0.01 eV, 0.05 eV, 0.08 eV, 0.09 eV, 0.1 eV, 0.11 eV, 0.12 eV, 0.15 eV, 0.2 eV, 0.3 eV, 0.4 eV, and 0.5 eV. By means of designing the sub-perovskite films according to the difference gradient, the optimum absorption corresponding to different spectral bands can be achieved, the light wave energy of different wavelengths in the spectrum is maximized, and the photoelectric absorption and conversion efficiency is improved. In addition, based on the existence of a certain difference in the band gaps of two layers of the sub-perovskite films, the energy gap difference between the layers can be reduced, and the extraction and transmission of photogenerated carriers can be promoted.

In some examples, the band gap difference between two adjacent layers of the sub-perovskite films is 0.05 eV-0.2 eV. Further, the band gap difference between two adjacent layers of the sub-perovskite films is 0.08 eV-0.12 eV.

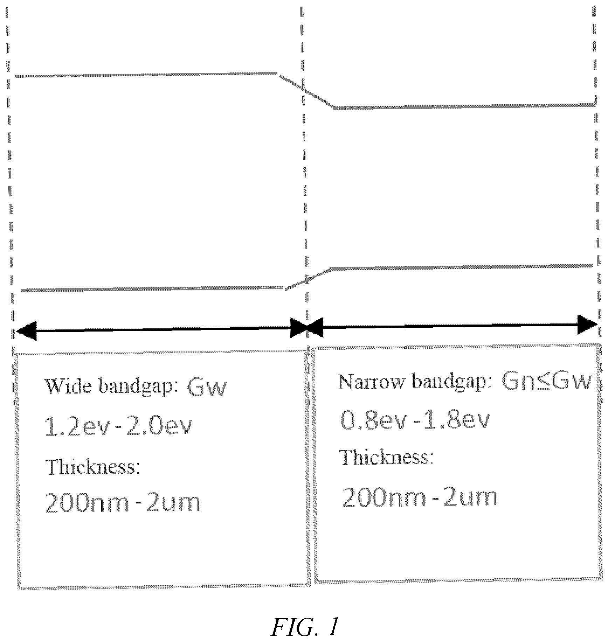

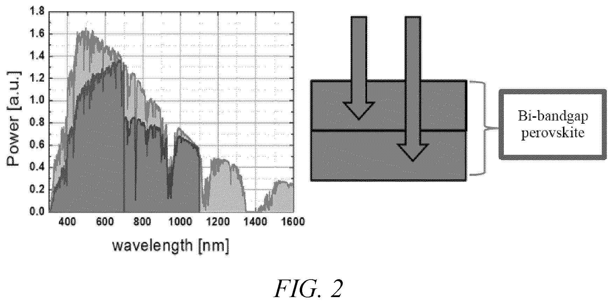

In some examples, the several layers of sub-perovskite films include at least one wide-band-gap layer and one narrow-band-gap layer, wherein the wide-band-gap layer has a band gap G_{w} of 1.2 eV-2.0 eV, the narrow-band-gap layer has a band gap Gₙ of 0.8 eV-1.8 eV, and Gₙ ≤ G_{w}. As an example, the band gap matching of the wide-band-gap layer and the narrow-band-gap layer and the thicknesses thereof are shown in Fig. 1, and the schematic diagram of the absorption spectrum is shown in Fig. 2.

In some examples, the sub-perovskite film is an evaporated film.

In some examples, in any two adjacent layers of sub-perovskite films, the sub-perovskite film with a wider band gap has a thickness of H1, the sub-perovskite film with a narrower band gap has a thickness of H2, and H1 < H2.

In some examples, the sub-perovskite film has a thickness of 200 nm-2 µm. Specifically, the thickness of the sub-perovskite film includes but is not limited to: 200 nm, 300 nm, 350 nm, 380 nm, 400 nm, 420 nm, 450 nm, 500 nm, 530 nm, 550 nm, 570 nm, 600 nm, 650 nm, 700 nm, 800 nm, 900 nm, 1 µm, 1.5 µm, and 2 µm.

In some examples, the sub-perovskite film has a thickness of 300 nm-1 µm. Further, the sub-perovskite film has a thickness of 300 nm-600 nm.

In some examples, the sub-perovskite film is a material selected from one or more of compounds as represented by the following structural formula (I):

ABX₃ (I).

wherein A represents one or more mixed cations. It can be understood that the cation may refer to an organic cation, an inorganic cation or an organic-inorganic mixed cation at a different ratio.

In some examples, A includes one or more of a methylamine cation (MA⁺), a formamidine cation (FA⁺) and a cesium ion (Cs⁺). By means of using a suitable A, an iodine-lead octahedral structure can be better stabilized and the stability of a device is improved, wherein B represents one or more mixed cations. It can be understood that the cation may refer to an organic cation, an inorganic cation or an organic-inorganic mixed cation at a different ratio.

In some examples, B includes one or more mixed metal cations; and further, B comprises one or more of Pb²⁺, Sn²⁺ and Ge²⁺. By means of using a suitable B, the band gap of a device can be adjusted and controlled and the performance of the device can be improved,
wherein X represents one or more mixed halide anions. This is not limited that X includes one or more of Cl⁻, Br⁻and I⁻.

In some examples, the perovskite solar cell is a thin film cell.

In some examples, the bottom electrode is used for light incidence, and is specifically a transparent conductive substrate. This is not limited that the bottom electrode may be a glass substrate or a flexible substrate. Specifically, the flexible substrate can be an organic polymer material, such as one or more of a polyvinyl alcohol (PVA), a polyester (PET), a polyimide (PI), a polyethylene naphthalate (PEN) and polydimethylsiloxane (PDMS).

The material of the top electrode is not limited and may be an organic, inorganic or mixed, in different ratios, organic and inorganic conductive material. In some examples, the material of the top electrode can be a metal conductive material, such as gold (Au), silver (Ag), copper (Cu) or a mixture thereof, or a conductive oxide, such as FTO, and ITO.

In addition, in some examples, the perovskite solar cell further includes one or both of an electron transport layer and a hole transport layer. Specifically, the perovskite solar cells include regular and inverted cells. For the regular cell, the perovskite solar cell includes a bottom electrode and an electron transport layer, a perovskite layer, a hole transport layer and a top electrode sequentially stacked on the bottom electrode. For the inverted cell, the perovskite solar cell includes a bottom electrode and a hole transport layer, a perovskite layer, an electron transport layer and a top electrode sequentially stacked on the bottom electrode.

The material of the electron transport layer is not limited and includes one or a mixture of one or more of the following materials and derivatives thereof: an imide compound, a quinone compound, fullerene and a derivative thereof, methoxytriphenylamine-fluoroformamidine (OMeTPA-FA), calcium titanate (CaTiO₃), lithium fluoride (LiF), calcium fluoride (CaF₂), poly(3,4-ethylenedioxythiophene) : styrenesulfonate (PEDOT : PSS), poly 3-hexylthiophene (P₃HT), triptycene-cored triphenylamine (H101), 3,4-ethylenedioxythiophene-methoxytriphenylamine (EDOT-OMeTPA), N-(4-aniline)carbazole-spirobifluorene (CzPAF-SBF), polythiophene, metal oxides (the metal element is selected from Mg, Ni, Cd, Zn, In, Pb, Mo, W, Sb, Bi, Cu, Hg, Ti, Ag, Mn, Fe, V, Sn, Zr, Sr, Ga or Cr), silicon oxide (SiO₂), strontium titanate (SrTiO₃), and cuprous thiocyanate (CuSCN).

The material of the hole transport layer is not limited and includes one or a mixture of one or more of the following materials and derivatives thereof: 2,2',7,7'-tetra[N,N-bis(4-methoxyphenyl)amino]-9,9'-spirobifluorene (Spiro-OMeTAD), polytriarylamine (PTAA), NiOx, poly 3,4-ethylenedioxythiophene : poly(styrenesulfonate) (PEDOT : PSS), and WO₃.

The present application also provides a method for preparing a perovskite solar cell, the method comprising the steps of:
preparing a perovskite layer on a surface of the bottom electrode, the perovskite layer comprising several layers of sub-perovskite films arranged in stack, and the band gaps of two adjacent layers of the sub-perovskite films being different; and
preparing a top electrode on the surface of the perovskite layer.

In some examples, the sub-perovskite films are prepared by means of an evaporation method. The preparation of sub-perovskite film by means of an evaporation method can ensure the independence between the sub-perovskite films, that is while the band gap width and thickness of the preceding sub-perovskite film are controllable, the interface processing window of the following sub-perovskite film is increased, such that the band gap width and thickness of the latter sub-perovskite film are also controllable, the damage to the preceding sub-perovskite film is reduced, the interpenetration and interdoping between each sub-perovskite film and the defect layer formation are reduced, and inconsistent performance of a device is avoided, which in turn ensures that the thicknesses and band gaps of the sub-perovskite films are controllable, such that the spectral absorption and conversion range is increased.

The preparation by means of an evaporation method is not limited and can involve co-evaporating materials in an on-line or in-situ manner. Co-evaporated materials can be AX and BX₂, respectively.

In some examples, the evaporation method has an evaporation temperature of 100°C-300°C. The evaporation temperature can be achieved by controlling the current source on an evaporation apparatus, that is, the temperature can be adjusted and controlled by adjusting and controlling the current.

In some examples, the evaporation distance of the evaporation method is 10 cm-50 cm. Specifically, the evaporation distance of the evaporation method includes but is not limited to: 10 cm, 15 cm, 20 cm, 25 cm, 30 cm, 40 cm, and 50 cm. Further, the evaporation distance is 10 cm-30 cm.

In some examples, the vacuum degree of the evaporation method is (0.5 - 3) × 10⁻⁶ mbar. Specifically, the vacuum degree of the evaporation method includes but is not limited to: 0.5 × 10⁻⁶ mbar, 0.8 × 10⁻⁶ mbar, 1 × 10⁻⁶ mbar, 1.2 × 10⁻⁶ mbar, 1.5 × 10⁻⁶ mbar, 2 × 10⁻⁶ mbar and 3 × 10⁻⁶ mbar.

In some examples, during the evaporation by means of the evaporation method, the substrate is rotated, at a substrate temperature of 15°C-30°C. Specifically, the substrate temperature includes but is not limited to: 15°C, 17°C, 18°C, 19°C, 20°C, 21°C, 22°C, 23°C, 25°C, 27°C and 30°C.

In some examples, after the evaporation of several layers of perovskite films is completed, an annealing step is also included. The annealing and crystallization are performed together after the evaporation of the sub-perovskite films, which can save processing and realize the preparation of different band gap structures of the absorption conversion layer simultaneously. The annealing and crystallization are not limited and also may be performed after the evaporation of a single-layer sub-perovskite film is completed, and each sub-perovskite film is prepared by step evaporation and annealing.

In some examples, the annealing temperature is 110°C-140°C. Specifically, the annealing temperature includes but is not limited to: 110°C, 120°C, 130°C, 135°C and 140°C.

In some examples, the annealing time is 3-20 minutes. Specifically, the time of annealing includes but is not limited to: 3 minutes, 5 minutes, 8 minutes, 10 minutes, 13 minutes, 15 minutes, 17 minutes, and 20 minutes.

In some examples, the annealing conditions include: a temperature of 110°C-140°C and a time of 3-20 minutes.

The perovskite solar cell in the above preparation method and the advantages thereof are the same as those of the aforementioned perovskite solar cell provided in the present application, and will not be repeated here.

The present application also provides a power consuming device, comprising a perovskite solar cell as described above or a perovskite solar cell prepared by a preparation method as described above.

### Examples

In order to make the technical problems solved by the present application, the technical solutions and the beneficial effects clearer, further detailed description of the present application will be given below with reference to the examples and the accompanying drawings. Apparently, the described examples are merely some, rather than all, of the examples of the present application. The following description of at least one exemplary example is merely illustrative in nature and is in no way to limit the present application and the use thereof. All other examples obtained by those of ordinary skill in the art based on the examples of the present application without involving any inventive effort shall fall within the scope of protection of the present application.

The examples in which techniques or conditions are not specified are based on the techniques or conditions described in documents in the art or according to the product introduction. The reagents or instruments used therein for which manufacturers are not specified are all conventional products that are commercially available.

### Preparation example 1

1) a set of FTO conductive glass with specifications of 30 cm * 30 cm, 0.5 m * 1 m, and 1 m * 2 m is subjected to laser etching to form P1 having a width of 30 µm, the FTO conductive layer on the whole glass is cut and insulated, and then divided into several sub-cell electrodes;
2) the etched conductive glass surface is sequentially washed with acetone and isopropanol twice, immersed in deionized water for an ultrasonic treatment for 10 min, then dried in a blast drying oven, and then placed in a drying room (humidity of 2% or less), to obtain a first electrode (a bottom electrode).
3) the washed conductive glass is placed into magnetron sputtering to deposit a layer of hole transport layer of NiO with a film thickness of about 15 nm; and
4) after the hole transport layer is prepared, a perovskite light-absorbing layer is prepared by means of a multi-source co-evaporation method, in which lead iodide is used as a lead source and an iodine source, and MAI/FAI is used as a methylamine/formamidine source and an iodine source:
   4.1 preparation of a film with a wide-band-gap of about 1.62 eV: the selected perovskite component being MAPbI₃, the method being a dual-source co-evaporation method, in which lead iodide is used as a lead source and an iodine source, MAI is used as an methylamine source and an iodine source, 500 mg MAI and 300 mg PbI₂ as two sources, are evaporated at 120°C and 295°C, respectively, the thickness of the evaporated film is controlled at about 330 nm, with the substrate being rotated during the evaporation, and is cooled with water to about 21°, the evaporation distance is about 20 cm, and the vacuum degree is controlled at 1 × 10⁻⁶ mbar;
   4.2 preparation of a film with a narrow-band-gap about 1.51 eV: the selected perovskite component being FAPbI₃, the method being also a dual-source co-evaporation method, in which lead iodide is used as a lead source and an iodine source, 1000 mg FAI is used as a formamidine source and an iodine source, the above-mentioned MAI source is turned off, the FAI source is turned on, the evaporation temperature is adjusted and controlled to 165°C, and the PbI₂ source remains still, the thickness of the evaporation film is controlled at about 500 nm, with the substrate being rotated during the evaporation, and is cooled with water to about 21°, the evaporation distance is about 20 cm, and the vacuum degree is controlled at 1 × 10⁻⁶ mbar; and
   4.3 after the preparation of the dry two-band gap perovskite films is completed, placing the substrate in a crystallization furnace and annealing same at 140°C for 15 minutes, removing same after cooling for the next step.
5) the substrate with the perovskite absorption layer prepared is placed into the vacuum thermal evaporation equipment, vacuuming is performed to 4 × 10⁻⁴ Pa, and depositing 30 nm C60-N and 8 nm BCP as an assembly, i.e., an electron transport layer;
6) after the electron transport layer is deposited in the vacuum thermal evaporation equipment, 10 nm Cu is continuously deposited on the surface thereof, and then same is removed after vacuum-breaking, and is subjected to laser etching to form P2 having a width of 150 µm and an etching depth to the FTO layer, and the interval between P2 and P1 being 20 µm; and then the substrate is placed into the evaporation equipment again and vacuuming is performed to 4 × 10⁻⁴ Pa, and then a layer of Cu is continuously deposited, with a thickness of about 80 nm;
7) after being cooled, same is removed after vacuum breaking and subjected to laser etching to form P3 having a width of 15 µm, and an etching depth to the FTO layer, the interval between P3 and P2 being 20 µm, (the position of the etching line is P1/P2/P3 in sequence);
8) then the assembly is subjected to edge bead removal using infrared laser, that is, each of two sides of the assembly is etched away by 10 mm to obtain an assembly of a perovskite solar cell; and
9) in AAA level steady state solar simulator, parameters of assemblies tested at 1000 W/m² and 25°C.

The method for preparing an assembly of a perovskite solar cell of examples 2-5 and comparative example 1 is similar to the preparation method of example 1, except that the thicknesses of a wide-band-gap film layer and a narrow-band-gap film layer are changed, thereby changing the band gaps.

The method for preparing an assembly of a perovskite solar cell of comparative example 2 is similar to that of example 1, except that a perovskite light-absorbing layer in step 4) is prepared by means of a solvent method, comprising the following steps:
4.1 preparation of a film with a wide-band-gap of about 1.62 eV: the selected perovskite component being MAPbI₃, the perovskite precursor solution comprising N,N-dimethylformamide and dimethyl sulfoxide at a solvent volume ratio of 4 : 1 as a solvent, 1.2 mol/L of lead iodide, and 1.2 mol/L of methylamine hydroiodate, the spin-coating condition involving 3000 rpm and 30 s, dropwise adding an anti-solvent in the remaining 5 s, and annealing being performed at 100°C for 30 min; and
4.2 preparation of a film with a narrow-band-gap about 1.51 eV: the selected perovskite component being FAPbI₃, the perovskite precursor solution comprising N,N-dimethylformamide and dimethyl sulfoxide at a solvent volume ratio of 4 : 1 as a solvent, 1.2 mol/L of lead iodide, and 1.2 mol/L of formamidine hydroiodate, the spin-coating condition involving 5000 rpm and 30 s, dropwise adding an anti-solvent in the remaining 5 s, and annealing being performed at 140°C for 10 min.

The parameters and test results of the assemblies of the perovskite solar cells prepared in examples 1-5 and comparative examples 1-2 are shown in Table 1.

**Table 1**

| | Thickness of wide-band-gap (nm) | Thickness of narrow-band-gap (nm) | Jsc (mA/cm²) | Voc (V) | FF (%) | PCE (%) |
|---|---|---|---|---|---|---|
| Comparative example 1 | 520 | 0 | 19.61 | 0.92 | 75.95 | 13.75 |
| Comparative example 2 | unknown (no clear interface) | unknown (no clear interface, the total thickness of wide and narrow-band-gap is 600 nm) | 16.32 | 0.57 | 59.40 | 5.52 |
| Example 1 | 330 | 500 | 19.58 | 1.05 | 74.30 | 15.30 |
| Example 2 | 400 | 500 | 21.76 | 0.98 | 73.54 | 15.71 |
| Example 3 | 300 | 450 | 20.80 | 0.999 | 76.14 | 15.83 |
| Example 4 | 400 | 550 | 23.72 | 1.086 | 68.76 | 17.71 |
| Example 5 | 400 | 600 | 24.09 | 1.041 | 66.59 | 16.69 |

It can be known from Table 1 that all of examples 1-5 can achieve better performance of a device than comparative examples 1-2, especially in comparative example 2, the interface between wide and narrow-band-gap layers is blurred, which leads to the appearance of defects, and then the performance of a device is degraded. In examples 1-5, when the thickness of the wide-band-gap perovskite is 400 nm and the thickness of the narrow-band-gap perovskite is 550 nm, the performance of a device is optimal.

It should be noted that the present application is not limited to the above embodiments. The above implementations are only examples, and all implementations within the scope of the technical solution of the present application that have substantially the same composition and have the same effect as the technical concept are encompassed in the technical scope of the present application. In addition, without departing from the scope of the subject matter of the present application, various modifications that may be conceived by those skilled in the art to the implementations, and other modes constructed by combining some of the constituent elements of the implementations are also encompassed in the scope of the present application.

## Claims

1. **A perovskite** solar cell, comprising a bottom electrode, a perovskite layer and a top electrode, wherein the perovskite layer comprises several layers of sub-perovskite films arranged in stack, and the band gaps of two adjacent layers of the sub-perovskite films are different.

2. The perovskite solar cell of claim 1, **characterized in that** the band gaps of the several layers of the sub-perovskite films sequentially vary from large to small; and optionally, the bottom electrode is a transparent electrode, and the band gaps of the several layers of the sub-perovskite films sequentially vary from large to small in the direction from the bottom electrode to the top electrode.

3. The perovskite solar cell of either of claims 1-2, **characterized in that** the sub-perovskite films have a number of layers of 2-10; optionally, the sub-perovskite films have a number of layers of 2-5; and further optionally, the sub-perovskite films have a number of layers of 2-3.

4. The perovskite solar cell of any one of claims 1-3, **characterized in that** the band gap difference between two adjacent layers of the sub-perovskite films is 0.01 eV-0.5 eV; optionally, the band gap difference between two adjacent layers of the sub-perovskite films is 0.05 eV-0.2 eV; and further optionally, the band gap difference between two adjacent layers of the sub-perovskite films is 0.08 eV-0.12 eV.

5. The perovskite solar cell of any one of claims 1-4, **characterized in that** the several layers of sub-perovskite films include at least one wide-band-gap layer and one narrow-band-gap layer, wherein the wide-band-gap layer has a band gap G_{w} of 1.2 eV-2.0 eV, the narrow-band-gap layer has a band gap Gₙ of 0.8 eV-1.8 eV, and Gₙ ≤ G_{w}.

6. The perovskite solar cell of any one of claims 1-5, **characterized in that** the sub-perovskite films are evaporated films.

7. The perovskite solar cell of any one of claims 1-6, **characterized in that** the sub-perovskite films have a thickness of 200 nm-2 µm; optionally, the sub-perovskite films have a thickness of 300 nm-1 µm; and further optionally, the sub-perovskite films have a thickness of 300 nm-600 nm.

8. The perovskite solar cell of any one of claims 1-7, **characterized in that** the sub-perovskite films are a material selected from one or more of compounds as represented by the following structural formula (I):
ABX₃ (I)
wherein A represents one or more mixed cations; and optionally, A comprises one or more of a methylamine cation, a formamidine cation and a cesium ion;
B represents one or more mixed cations; optionally, B comprises one or more mixed metal cations; and further optionally, B comprises one or more of Pb²⁺, Sn²⁺ and Ge²⁺; and
X represents one or more mixed halide anions; and optionally, X comprises one or more of Cl⁻, Br⁻ and I⁻.

9. The perovskite solar cell of any one of claims 1-8, **characterized in that** the perovskite solar cell is a thin film cell.

10. A method for preparing a perovskite solar cell, the method comprising the steps of:
preparing a perovskite layer on a surface of the bottom electrode, the perovskite layer comprising several layers of sub-perovskite films arranged in stack, and the band gaps of two adjacent layers of the sub-perovskite films being different; and
preparing a top electrode on the surface of the perovskite layer.

11. The method for preparing a perovskite solar cell of claim 10, **characterized in that** the sub-perovskite films are prepared by means of an evaporation method.

12. The method for preparing a perovskite solar cell of claim 11, **characterized in that** when the sub-perovskite films are prepared by means of an evaporation method, at least one of the following characteristics is satisfied:
(1) an evaporation temperature is 100°C-300°C;
(2) an evaporation distance is 10 cm-50 cm; and optionally, the evaporation distance is 10 cm-30 cm;
(3) a degree of vacuum is (0.5 - 3) × 10⁻⁶ mbar;
(4) during the evaporation, the substrate is rotated, at a substrate temperature of 15°C-30°C; and
(5) after the evaporation of several layers of perovskite films is completed, an annealing step is also included; and optionally, the annealing conditions include: a temperature of 110°C-140°C and a time of 3-20 minutes.

13. The method for preparing a perovskite solar cell of any one of claims 10-12, **characterized in that** the band gaps of the several layers of the sub-perovskite films sequentially vary from large to small; and optionally, the bottom electrode is a transparent electrode, and the band gaps of the several layers of the sub-perovskite films sequentially vary from large to small in the direction from the bottom electrode to the top electrode.

14. The method for preparing a perovskite solar cell of any one of claims 10-13, **characterized in that** the sub-perovskite films have a number of layers of 2-10; optionally, the sub-perovskite films have a number of layers of 2-5; and further optionally, the sub-perovskite films have a number of layers of 2-3.

15. The method for preparing a perovskite solar cell of any one of claims 10-14, **characterized in that** the band gap difference between two adjacent layers of the sub-perovskite films is 0.01 eV-0.5 eV; optionally, the band gap difference between two adjacent layers of the sub-perovskite films is 0.05 eV-0.2 eV; and further optionally, the band gap difference between two adjacent layers of the sub-perovskite films is 0.08 eV-0.12 eV.

16. The method for preparing a perovskite solar cell of any one of claims 10-15, **characterized in that** the several layers of sub-perovskite films include at least one wide-band-gap layer and one narrow-band-gap layer, wherein the wide-band-gap layer has a band gap G_{w} of 1.2 eV-2.0 eV, the narrow-band-gap layer has a band gap Gₙ of 0.8 eV-1.8 eV, and Gₙ ≤ G_{w}.

17. The method for preparing a perovskite solar cell of any one of claims 10-16, **characterized in that** the sub-perovskite films have a thickness of 200 nm-2 µm; optionally, the sub-perovskite films have a thickness of 300 nm-1 µm; and further optionally, the sub-perovskite films have a thickness of 300 nm-600 nm.

18. The method for preparing a perovskite solar cell of any one of claim 10-17, **characterized in that** the sub-perovskite films are a material selected from one or more of compounds having as represented by the following structural formula (I):
ABX₃ (I)
wherein A represents one or more mixed cations; and optionally, A comprises one or more of a methylamine cation, a formamidine cation and a cesium ion;
B represents one or more mixed cations; optionally, B comprises one or more mixed metal cations; and further optionally, B comprises one or more of Pb²⁺, Sn²⁺ and Ge²⁺; and
X represents one or more mixed halide anions; and optionally, X comprises one or more of Cl⁻, Br⁻ and I⁻.

19. A power consuming device, comprising a perovskite solar cell selected from any one of claims 1-9 or a perovskite solar cell prepared by means of a preparation method of any one of claims 10-18.
